# EUROPEAN PATENT SPECIFICATION

(11) **EP 3 155 883 B1**
(45) Date of publication and mention of the grant of the patent: **02.01.2019**
(21) Application number: 15726969.7
(22) Date of filing: 05.06.2015
(51) Int. Cl.: H05K 7/20, H05K 7/14

(54) **SUBSEA COOLING ASSEMBLY**
UNTERWASSERKÜHLUNGSANORDNUNG
ENSEMBLE DE REFROIDISSEMENT SOUS-MARIN

(30) Priority: 11.06.2014 NO 20140733
(43) Date of publication of application: 19.04.2017
(73) Proprietor: FMC Kongsberg Subsea AS, 3601 Kongsberg (NO)
(72) Inventor: FØLKNER, Stein, 1361 Østerås (NO)
(74) Representative: Onsagers AS
(86) International application number: PCT/EP2015/062535
(87) International publication number: WO 2015/189093

(56) References cited:
- EP-A1- 2 579 438
- EP-A2- 2 131 639
- WO-A1-01/13692
- WO-A1-2010/058274
- US-A1- 2010 208 446

## Description

The invention concerns a subsea cooling assembly, and a subsea system including at least two subsea cooling assemblies.

In accordance with the invention, the subsea cooling assembly is applied for the cooling of electronics or power components. The electronics or power components may be used for controlling or manipulating the characteristics of a motor. For instance the electronics or power components may comprise a variable speed drive employed to control the speed of a motor of a compressor, water pump, a fan or other devices wherein a variable speed motor may be used for varying the speed of the motor.

Typical electronics or power components for enclosure in the subsea cooling assembly in accordance with the invention may include IGBTs, MOSFETs, diodes, thyristors, GTOs, inductors, transformers, resistors, capacitors, gate drivers, power supplies, batteries, control electronics, etc.

### Field of the invention

One field of use for the subsea cooling assembly in accordance with the invention is a subsea application such as for instance a subsea pump application, and more specifically a variable speed drive for a subsea pump application. As some of the electronic components used in variable speed drives have high thermal losses, an efficient cooling of the electronic or power components in these circumstances is necessary for the efficient working and reliability of the system. The subsea cooling assembly in accordance with the invention may also be applied to other passive cooled subsea power modules, e.g. amplifiers for magnetic bearing systems, power supplies, UPS modules, FACTS (Flexible Alternating Current Transmission Systems) modules, HVDC modules, SMART GRID modules or even sort of actively cooled system where seawater is pushed passing the cooling assembly according to the invention.

Consequently it is desirable to provide a reliable and effective concept for cooling of power or electronic components in atmospheric enclosures for use in a subsea variable speed drive system. As the need for a simpler and efficient cooling of power or electronic components also has other fields of use than in a subsea variable speed drive, it is an object of the invention to provide an efficient cooling arrangement for power or electronic components which is applicable for subsea use as such.

### Background

Various systems are known for the cooling of electronic or power component to be used subsea. In some cooling systems, a cooling arrangement is provided for the active cooling of the electronic or power component arranged inside an housing. Other cooling systems include passive cooling of subsea electronic components utilizing the surrounding seawater as a cooling medium, by heat conduction through the pressure shell, preferably cylindrical, and heat convection to ambient seawater. A problem with this system that still has to been solved is how to ensure the efficient transfer of heat between the electronic or power component and the seawater.

One prior art solution for passive cooling of electronic or power component which are arranged inside 1 atmosphere enclosures comprises mounting of components on heat sinks having an outer curvature that matches the inner diameter of a cylindrical pressure housing. The heat sinks are installed in the housing, and the required contact pressure between the heat sink and the housing is provided by an expansion mechanism or by the use of bolts. This solution has several disadvantages; the heat from the power components needs to be transferred through a number of heat conducting elements that are arranged in series and out to the seawater and this is not very efficient. Further as the installation of the electronic or power component needs to be installed inside the cylindrical housing, the cylindrical housing must be provided with a certain size to make the installation possible. Also the surfaces of the cylindrical housing need to match the curvature of the heat sink to make sure that the heat transfer occurs efficiently and this requires accurate machining when manufacturing the matching surfaces of the cylindrical housing and the heat sink.

As mentioned above it is well known within the field to provide the heat sink device as a cylindrical shaped pressure housing, and use heat sink segments internally to transfer heat from the electronic or power component to the pressure shell. Currently variable speed drives to be used subsea are being developed using active cooling. In accordance with this development a coolant fluid is circulated in a closed circuit that transports heat from active components inside the enclosure to a natural convection cooler externally of the enclosure. This solution provides effective cooling, but adds complexity and increases the number of failure modes compared to a passive system. An example of assembly for cooling of electronic components using an electrically conductive coolant is described in EP 2645839.

The prior art also include a solution with an rectangular pressure housing for submerged electronics. In WO 2012/158289 a rectangular box, with power electronics positioned in grooves in the bottom and a plate at the open end is disclosed. However the plate at the top will buckle at higher pressures as this is not supported otherwise than along the outer rim.

Another example of a cooling arrangement is shown in WO 01/08218. This publication discloses an open framed assembly of semiconductor devices which are arranged with a cooling arrangement and provided so that it is self cleaning.

EP 2579438 A1 discloses a power cell for deep-water applications having a power cell housing made of an insulating material.

US 2010/208446 A1 discloses an electronic power converter comprising three phase modules which are interconnected by connection elements arranged inside a cylindrical space.

WO 2010/058274 A1 discloses an electric power circuit which is completely housed in an outer sealed casing and directly immersed in an electrically insulating, cooling liquid contained within the sealed casing.

EP 2131639 A2 discloses a subsea electronics module for a well installation, comprising a housing, printed circuit boards and a communications component for enabling communication between the printed circuit boards.

WO 01/13692 A1 discloses a pressure vessel for passive conduction of heat generated by current-carrying components inside the vessel shell. The current-carrying components are mounted to a heat conducting element which is placed circumferentially against the inner wall of the vessel shell.

It is an object for the invention to provide a subsea cooling assembly using the surrounding seawater as a cooling medium and ensuring that the transfer of heat between the electronic or power components is efficient, while at the same time providing a subsea cooling assembly able to withstand the pressure load occurring at considerable sea depths. It is further an object for the invention to provide a subsea cooling assembly which makes an easy installation of power and electronic components possible.

The cooling assembly suitable for cooling using ambient sea water in accordance with the invention combines the possibility of easy access to the installation area for accommodation of the components with an overall stiffness of the cooling assembly to endure ambient pressure such as hydrostatic.

The basis idea for the invention has been to provide a pressure housing which is preferably non-cylindrical, and which allows mounting of the power components directly to the pressure boundary. The cooling assembly in accordance with the invention will reduce the number of thermal contact resistances, and thereby potentially reduce the total thermal resistance between the heat source and ambient seawater. Further the cooling assembly is provided with additional support compared to prior art solutions to prevent critical deformation of the pressure shell. The cooling assembly in accordance with the invention is prepared for a more optimized assembly process, as the layout provides unobstructed access for the mounting and wiring electronic and power components in the cooling assembly.

### Summary of the invention

The subsea cooling assembly according to the invention comprises a block module for the accommodation of electronics or power components and a cover element. The block module is arranged with at least one recess wherein the electronics or power components is arranged in the at least one recess of the block module for the transfer of heat between the electronics or power components and the surrounding sea through the block module. The cover element has outer rim portions arranged to fit with outer rim portions of the at least one recess for closing off the interior of the at least one recess. The block module has at least one strength supporting structure arranged to provide load support to at least a portion of the cover element which is distanced away from the outer rim portions of the cover element.

The outer rim portions of the at least one recess may be located close to outer rim portions of the block module or further away from the outer rim portions of the block module, depending on the configuration, position and the number of the recess(es). In one aspect the recess(es) may be provided with a slanting configuration wherein portions of the outer rim portions of the recess(es) closer to outer rim portions of the block module have a close distance to the cover element when installed, whereas other portions of the recess(es) further away from the outer rim portions of the block module are distanced further away from the installed cover element. Also the recess(es) may be shaped so that outer rim portions of the recess essentially coincide with outer rim portions of the block module.

Thus the at least one strength supporting structure may be arranged to offer support to any portion of the cover element in between outer rim portions of the cover element. This may be portions close to the outer rim portions of the cover element, positioned at a mid-area in between the outer rim portions or a continuous portion extending across the from one outer rim portions of the cover element to outer rim portions at another side of the cover element.

The at least one strength supporting structure may be arranged extending in a transverse direction across the block module from one side portion of the block module to an opposing side portion of the block module. The side portion of the block module may coincide with the outer rim portions of the block module or may be distanced somewhat away from the rim portions. The at least one strength supporting structure may be arranged extending in a transverse direction across the at least one recess from one side portion of the block module to an opposing side portion of the block module.

The at least one strength supporting structure may be arranged defining at least an inner wall of a recess. The recess may then be divided into two separate compartments. Two strength supporting structures may be arranged at each side of a recess extending across from a side portion of the block module to another side portion of the block module wherein each supporting structure defines oppositely arranged inner walls of a recess or a compartment of a recess. In the case where the block module is arranged with plural recesses or compartments of a recess, a number of strength supporting structures may be arranged for defining the recesses or compartments of the recesses. The number of recesses and strength supporting structures may vary, as well as the configuration, dimension and orientation of the individual strength supporting structure and the recess in order to provide the cooling assembly with an easy access for installation and sufficient strength support to endure the applied load at a specific sea depth and at a chosen application or field of use.

The hyperbaric pressure load on the block module and cover element is taken by the at least one strength supporting structure in compression between the block module and cover element. When the block module is provided with more than one strength supporting structure, the spacing in between them may vary. In one aspect the maximum spacing between the strength supporting structures is limited by the allowed deflection of the mounting surface for the electronic and power components and the stiffness of the subsea cooling assembly, which may be provided by the combined stiffnes of the block module and the cover element mounted on to the block module.

The electronics or power components may be positioned on a mounting surface of the at least one recess. The electronics or power components may be mounted directly or indirectly to the mounting surface in a manner that allows for satisfactory transfer of heat from the electronics or power components to the block module. The mounting surface may be any of the surfaces of the recess, and in one aspect the bottom surface of the recess may serve as a mounting surface, thereby facilitating the installation of the power and electronic components into the recess. The exterior of the block module may be provided with at least one cooling rib to enhance the cooling effect of the cooling assembly. In one aspect the longitudinal direction of the cooling rib may be arranged perpendicular to the direction of the strength supporting structure transverse across the block element. The combination of the strength supporting structure and the cooling ribs arranged perpendicular to the cooling ribs provides the cooling assembly with an overall stiffness suitable for withstanding pressure loads when submerged at considerable sea depths. The overall stiffness of the cooling arrangement may also be improved by the increase of the thickness of the block module and the cover element.

In addition or as an alternative to the cooling ribs the block module may be provided with a cooling arrangement comprising at least one cooling pipe element to increase the cooling effect of the cooling assembly.

In some circumstances a load bearing surface of the strength supporting structure is arranged in contact with portion(s) of the cover element when the cover element is arranged in a position closing off the interior of the at least one recess.

The cover plate is arranged to close off the interior of the recesses from the surrounding water when placed onto the block module. In this closed position the cover plate may be welded onto the block module or joined to the block module by using other sealing off methods for instance by employing gaskets in the sealing surface between the block module and the cover element.

The block module and the at least one strength supporting structure may be provided as one piece or the block module and the at least one strength supporting structure may be provided as separate elements manufactured in the same or different material. As the block module is arranged to transfer heat from the power or electronic components to the surrounding sea water it may be advantageous to manufacture the block module in a material of high thermal conductivity. The block module may be casted or forged, and the recesses of the block module may thereafter be machined or produced directly in the casting process, wherein the material which surrounds the individual recess makes up the at least one strength supporting structure. Or the block module can be provided for the later installment of the at least one strength supporting structure which is provided to be connected to the block thereby providing at least one recess. The block module may of course also be provided by the combination of pre manufactured recesses and later installed supporting structures.

The cover element and the block module may be shaped as plate structures, with squared cross sections arranged to fit the cover element onto the block. The cover element and the block module may of course also be provided having other configurations than plate structures with a squared cross section.

As an alternative to using the cover element for closing off the interior of the recesses, the cover element may be provided by another block module which is arranged to fit onto the first block module.

The invention also includes a subsea cooling system comprising the connection of at least two cooling assemblies. In accordance with the invention it is possible to connect a number of cooling assemblies to form a modularized system. In such a system a cooling assembly may be used for each phase in a VSD, or split redundant functions into A and B power modules. The cooling assemblies may be connected by steel tubes or oil filled cable hoses.

High pressure feed-through penetrators will typically be installed in the heat sink part of the enclosure. Wiring between the components and termination to the penetrators can thus be completed before the cover element is mounted, and allows for function testing of the cooling assembly before closing the interior of the recesses off for instance by seal welding of the cover.

### Description of the drawing

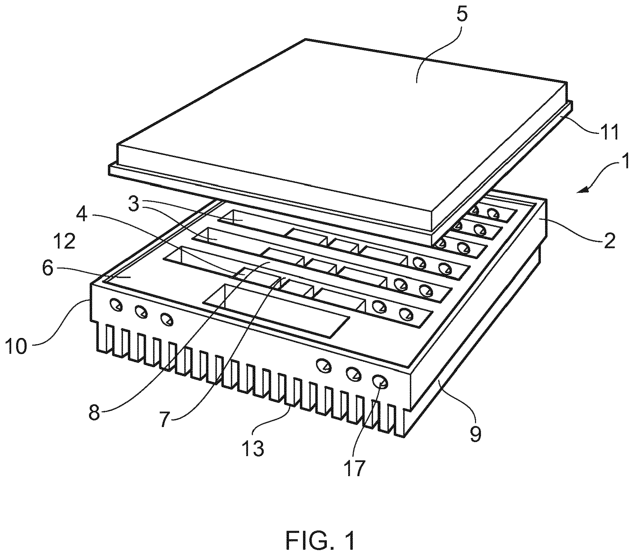

In the following, an example of one embodiment of the invention will be described in more detail with reference to fig. 1 which is a perspective view of an embodiment of the invention.

### Detailed description of the invention

Fig 1 shows an example of a subsea cooling assembly 1 in accordance with the invention, wherein a block module 2 has a recessed surface 6 arranged with a number of recesses 3 for accommodating electronics or power components 4. The electronics or power components 4 are placed in the recesses 3 in direct or indirect contact with a component mounting surface of the recess, for instance the bottom surface of the recess. In figure 1, the recesses 3 are shown having essentially equal size and are spaced side by side in a parallel relationship with essentially an equal distance between the recesses. However the configuration and dimensions of the recesses may vary according to the kind of electronics or power components 4 to be accommodated in the recesses. Each recess 3 may have an oblong shape as illustrated in figure 1 with a length extending from one side portion 9 to an oppositely arranged side portion 10 and may be arranged with a varying or uniform depth. The size and shape of the opening of the recess 3 into the recessed surface may vary. When the recessed surface 6 is provided with plural recesses as shown in figure 1, the size, configuration and orientation of the recesses may vary from one recess to the other or may be the same.

A cover element/a cover plate 5 is provided to be arranged onto the block module 2 to close off the interior of the recesses 3 from the surrounding water. The cover plate may be welded onto the block module 2 or joined to the block module otherwise in order to seal off the interior of the recesses 3 of the block module. As seen in the figure the block module 2 is arranged with an outer rim portion 12 which is arranged to fit with an outer rim portion 11 of the cover element 5

The cooling of the electronics or power components 4 located in the recesses occurs by passive cooling by the transfer of heat through the material of the block module 2 as the exterior of the block assembly is exposed to sea water. In the example shown in fig 1, the block module 2 is shown as a machined block which may be manufactured in a material of high thermal conductivity to enhance the transfer of heat through the block module 2 and arrange for an efficient cooling of the electronics or power components 4. The recesses 3 are provided to facilitate the installment of the electronics or power components 4 into the block module 2 and to ensure efficient cooling through the block module 2.

As the subsea cooling assembly 1 is to be used at considerable sea depths, the subsea cooling assembly 1 is arranged to endure hyperbaric pressures working on the block module 2 and the cover plate 5 at these sea depths. In order to provide the subsea cooling assembly with a stiffness for withstanding the pressures on the block module 2 and the cover plate 5, the block module 2 has at least a strength supporting structure 7 which in figure 1 is shown as a rib structure. The strength supporting surface 7 which in fig 1 is shown as a rib shaped structure has load bearing surface 8, and is arranged extending transversely across the block module 2 from the side portion 9 to the oppositely arranged side portion 10. As the block module 2 in this embodiment is shown as a plate structure, the oppositely arranged side portions are here constituted by the side surfaces of the plate. When the cover plate 5 is arranged onto the block module 2, so that the outer rim 11 of the cover plate is arranged to fit onto the outer rim 12 of the block module 2 at least one portion of the cover plate 5 distanced away from the outer rim portions of the cover element is supported by a load bearing surface 8 of the strength supporting structure 7.

In the embodiment of the block module as shown in fig 1, plural strength supporting structures 7 are provided side by side ensuring an evenly distributed support over surface of the cover element 5 facing the block module 2. The spacing between the strength supporting structures 7 determines the stiffness of the base module, and the maximum allowed spacing is determined by the deflection of the component mounting surface (not shown) in the recess 4. The strength supporting structures 7 may constitute the inner walls of the recess extending from one side surface of the block module 2 to the other side surface. As explained above when describing the recesses; the configuration, dimension and orientation of the individual strength supporting structure 7 may vary, and the strength supporting structure 7 may be provided uniform or non uniform in the direction transversely across the block module 2. The load bearing surface 8 of the strength supporting structure 7 may be arranged so that contact is established with corresponding portions of the cover element 5 when the cover element is brought into the closing position or the load bearing surface 8 may be distanced from the corresponding portions of the cover element 5, but dimensioned so that contact is established at specific ambient pressure conditions.

The strength supporting structure(s) 7 may be provided as an integrated part of the block module 2, wherein the strength supporting structure(s) 7 and the block module 2 are made in one piece ensuring an efficient heat transfer in between the components located in the recesses 4 and the sea water surrounding the block module 2. Alternatively the strength supporting structure(s) 7 may be provided separately from the block module 2 and arranged to be connected to the block module 2, the strength supporting structure(s) 7 may then be provided in the same or different material as the block module 2.

The sea water surrounding the block module 2 serves as the cooling medium for the cooling of the components located in the recesses 4. To optimize the heat exchange between the sea water and the block module 2, the exterior of the block module may be provided with a structure allowing efficient interface contact between the block module and the sea water. In this respect the block module may be provided as cooling ribs or cooling fins 13 extending in a direction which is perpendicular to the transversally arranged strength supporting structures 7. The orientation of the cooling ribs 13 perpendicular to the strength supporting structures 7 increases the overall stiffness of the block module 2. The combination of the strength supporting structures 7 and cooling fins 13 being arranged perpendicular to each other and the increase of the thickness of the base module 2 and the cover plate, provides the subsea cooling assembly with a possibility of three axial stiffness control. If needed the thickness of the cover plate 5 and the plate shaped block module 2 may also be increased.

The shown cooling fins 13 are shown as integral parts of the block module 2, but the cooling fins 13 may of course also be provided as addition equipment to be attached to the block module 2. In addition or as an alternative to the cooling ribs 13, a cooling arrangement such as a cooling pipe element may be provided.

In figure 1 the cover element 5 and the block module 2 are shown as plate structures, with squared cross sections arranged to fit the cover element onto the block, but the cover element 5 and the block module 2 may as the skilled person will realize also be provided having other configurations. Even if the cooling assembly may be given various configurations, it will be advantageous to the cooling effect that the cooling assembly is shaped so that the exterior has a large surface and a large the ratio between the exterior surface and the volume of the cooling assembly.

Installation holes 17 are shown for the insert of penetrators such as high pressure feed-through penetrators (not shown).

In an embodiment the cover element 7 may be substituted by another block module arranged onto the block module 2 to close off the interior of the recess(es).

The subsea cooling assembly 1 may be connected with other cooling assemblies to produce a modularized cooling system.

In the preceding description, various aspects of the apparatus according to the invention have been described with reference to the illustrative embodiment. For purposes of explanation, specific numbers, systems and configurations were set forth in order to provide a thorough understanding of the apparatus and its workings. However, this description is not intended to be construed in a limiting sense. Various modifications and variations of the illustrative embodiment, as well as other embodiments of the apparatus, which are apparent to persons skilled in the art to which the disclosed subject matter pertains, are deemed to lie within the scope of the present invention as defined in the in the attached claims.

## Claims

1. Subsea cooling assembly (1) comprising a block module (2) for the accommodation of electronics or power components (4) and a cover element (5), and the block module (2) is arranged with at least one recess (3) wherein the electronics or power components (4) are arranged in the at least one recess (3) of the block module (1) for the transfer of heat between the electronics or power components (4) and the surrounding sea through the block module (2), and the cover element (5) has outer rim portions (11) arranged to fit with outer rim portions (12) of the at least one recess (3) for closing off the interior of the at least one recess (3) wherein the block module (2) has at least one strength supporting structure (7) arranged to provide load support to at least a portion of the cover element (5) which is distanced away from the outer rim portions (11) of the cover element (5).

2. Subsea cooling assembly (1) in accordance with claim 1, wherein the at least one strength supporting structure (7) is arranged extending in a transverse direction across the block module (2) from one side portion (9) of the block module (2) to an opposing side portion (10) of the block module (2).

3. Subsea cooling assembly (1) in accordance with claim 1 or 2, wherein the at least one strength supporting structure (7) is arranged defining at least an inner wall of the recess (3).

4. Subsea cooling assembly (1) in accordance with one of the claims, wherein the electronics or power components (4) are positioned on a mounting surface of the at least one recess (3).

5. Subsea cooling assembly (1) in accordance with one of the claims, wherein the exterior of the block module (2) is provided with at least one cooling rib (13).

6. Subsea cooling assembly (1) in accordance with claim 5, wherein the longitudinal direction of the at least one cooling rib (13) is perpendicular to the direction of the strength supporting structure (7) transverse across the block element (2).

7. Subsea cooling assembly (1) in accordance with one of the claims 1-4, wherein the block module (2) is provided with a cooling arrangement comprising at least one cooling pipe element.

8. Subsea cooling assembly (1) in accordance with claim one of the preceding claims, wherein a load bearing surface (8) of the strength supporting structure (7) is arranged in contact with portion(s) of the cover element (5) when the cover element (5) is arranged in a position closing off the interior of the at least one recess (3).

9. Subsea cooling assembly (1) in accordance with claim one of the preceding claims, wherein the block module (2) and the at least one strength supporting structure (7) are provided as one piece.

10. Subsea cooling assembly (1) in accordance with claim one of the preceding claims, wherein the cover element (5) and the block module (2) are shaped as plate structures, with squared cross sections arranged to fit the cover element (5) onto the block module (2).

11. Subsea cooling assembly (1) in accordance with claim 1, wherein the cover element (5) is provided by another block module.

12. Subsea cooling system comprising the connection of at least two cooling assemblies (1) in accordance with one of the claims 1-11.

## Patentansprüche

1. Submarine Kühlanordnung(1), umfassend ein Blockmodul (2) zur Aufnahme von Elektronik- oder Leistungskomponenten (4) und ein Abdeckelement (5), wobei das Blockmodul (2) mit wenigstens einer Ausnehmung (3) versehen ist, wobei die Elektronik- oder Leistungskomponenten (4) in der wenigstens einen Ausnehmung (3) des Blockmoduls (1) zur Wärmeübertragung zwischen den Elektronik- oder Leistungskomponenten (4) und dem umgebenden Meer durch das Blockmodul (2) angeordnet sind, und das Abdeckelement (5) äußere Randabschnitte (11) aufweist, die zu äußeren Randabschnitten (12) der wenigstens einen Ausnehmung (3) passend angeordnet sind, um das Innere der wenigstens einen Ausnehmung (3) zu verschließen, wobei das Blockmodul (2) wenigstens eine Verstärkungsstruktur (7) aufweist, die dazu vorgesehen ist, wenigstens einem Abschnitt des Abdeckelementes (5), der in einem Abstand von den äußeren Randabschnitten (11) des Abdeckelementes (5) angeordnet ist, Auflageunterstützung zu bieten.

2. Submarine Kühlanordnung(1) nach Anspruch 1, wobei die wenigstens eine Verstärkungsstruktur (7) so angeordnet ist, dass sie sich in einer Querrichtung über das Blockmodul (2) von einem Seitenabschnitt (9) des Blockmoduls (2) bis zu einem gegenüberliegenden Seitenabschnitt (10) des Blockmoduls (2) erstreckt.

3. Submarine Kühlanordnung(1) nach Anspruch 1 oder 2, wobei die wenigstens eine Verstärkungsstruktur (7) so angeordnet ist, dass sie wenigstens eine Innenwand der Ausnehmung (3) festlegt.

4. Submarine Kühlanordnung(1) gemäß einem der vorhergehenden Ansprüche, wobei die Elektronik- oder Leistungskomponenten (4) an einer Montagefläche der wenigstens einen Ausnehmung (3) positioniert sind.

5. Submarine Kühlanordnung(1) gemäß einem der vorhergehenden Ansprüche, wobei das Blockmodul (2) außen mit wenigstens einer Kühlrippe (13) versehen ist.

6. Submarine Kühlanordnung(1) nach Anspruch 5, wobei die Längsrichtung der wenigstens einen Kühlrippe (13) senkrecht zur Richtung der quer über das Blockelement (2) verlaufenden Verstärkungsstruktur (7) verläuft.

7. Submarine Kühlanordnung(1) gemäß einem der Ansprüche 1 bis 4, wobei das Blockmodul (2) mit einer Kühlanordnung versehen ist, die wenigstens ein Kühlrohrelement umfasst.

8. Submarine Kühlanordnung(1) nach einem der vorhergehenden Ansprüche, wobei eine Auflagefläche (8) der Verstärkungsstruktur (7) in Kontakt mit einem oder mehreren Abschnitten des Abdeckelementes (5) angeordnet ist, wenn das Abdeckelement (5) in einer Position zum Verschließen des Inneren der wenigstens einen Ausnehmung (3) angeordnet ist.

9. Submarine Kühlanordnung(1) gemäß einem der vorhergehenden Ansprüche, wobei das Blockmodul (2) und die wenigstens eine Verstärkungsstruktur (7) einstückig ausgebildet sind.

10. Submarine Kühlanordnung(1) gemäß einem der vorhergehenden Ansprüche, wobei das Abdeckelement (5) und das Blockmodul (2) die Form von Plattenstrukturen mit quadratischen Querschnitten aufweisen, die so angeordnet sind, dass das Abdeckelement (5) auf das Blockmodul (2) passt.

11. Submarine Kühlanordnung(1) gemäß Anspruch 1, wobei das Abdeckelement (5) durch ein weiteres Blockmodul gebildet wird.

12. Submarine Kühlsystem, umfassend die Verbindung wenigstens zweier Kühlanordnungen (1) gemäß einem der Ansprüche 1 bis 11.

## Revendications

1. Ensemble de refroidissement sous-marin (1) comprenant un module de bloc (2) pour accueillir l'électronique ou des composants d'alimentation (4) et un élément couvercle (5), et le module de bloc (2) est agencé avec au moins un évidement (3), dans lequel l'électronique ou les composants d'alimentation (4) sont agencés dans l'au moins un évidement (3) du module de bloc (1) pour le transfert de chaleur entre l'électronique ou les composants d'alimentation (4), et la mer environnante par l'intermédiaire du module de bloc (2), et l'élément couvercle (5) comporte des portions de rebord extérieur (11) agencées pour s'ajuster avec des portions de rebord extérieur (12) de l'au moins un évidement (3) pour fermer l'intérieur de l'au moins un évidement (3), dans lequel le module de bloc (2) comporte au moins une structure de support de résistance (7) agencée pour fournir un support de charge à au moins une portion de l'élément couvercle (5) qui est à distance des portions de rebord extérieur (11) de l'élément couvercle (5).

2. Ensemble de refroidissement sous-marin (1) selon la revendication 1, dans lequel l'au moins une structure de support de résistance (7) est agencée s'étendant dans une direction transversale à travers le module de bloc (2) depuis une portion de côté (9) du module de bloc (2) jusqu'à une portion de côté opposé (10) du module de bloc (2).

3. Ensemble de refroidissement sous-marin (1) selon la revendication 1 ou 2, dans lequel l'au moins une structure de support de résistance (7) est agencée définissant au moins une paroi intérieure de l'évidement (3).

4. Ensemble de refroidissement sous-marin (1) selon l'une des revendications, dans lequel l'électronique ou les composants d'alimentation (4) sont positionnés sur une surface de montage de l'au moins un évidement (3).

5. Ensemble de refroidissement sous-marin (1) selon l'une des revendications, dans lequel l'extérieur du module de bloc (2) est pourvu d'au moins une ailette de refroidissement (13).

6. Ensemble de refroidissement sous-marin (1) selon la revendication 5, dans lequel la direction longitudinale de l'au moins une ailette de refroidissement (13) est perpendiculaire à la direction de la structure de support de résistance (7) transversale à travers l'élément de bloc (2).

7. Ensemble de refroidissement sous-marin (1) selon l'une des revendications 1 à 4, dans lequel le module de bloc (2) est pourvu d'un agencement de refroidissement comprenant au moins un élément tuyau de refroidissement.

8. Ensemble de refroidissement sous-marin (1) selon l'une des revendications précédentes, dans lequel une surface porteuse de charge (8) de la structure de support de résistance (7) est agencée en contact avec une ou des portions de l'élément couvercle (5) lorsque l'élément couvercle (5) est agencé dans une position fermant l'intérieur de l'au moins un évidement (3).

9. Ensemble de refroidissement sous-marin (1) selon l'une des revendications précédentes, dans lequel le module de bloc (2) et l'au moins une structure de support de résistance (7) sont prévus d'une seule pièce.

10. Ensemble de refroidissement sous-marin (1) selon l'une des revendications précédentes, dans lequel l'élément couvercle (5) et le module de bloc (2) sont formés en tant que structures de plaque, avec des sections transversales carrées agencées pour ajuster l'élément couvercle (5) sur le module de bloc (2).

11. Ensemble de refroidissement sous-marin (1) selon la revendication 1, dans lequel l'élément couvercle (5) est pourvu d'un autre module de bloc.

12. Système de refroidissement sous-marin comprenant le raccordement d'au moins deux ensembles de refroidissement (1) selon l'une des revendications 1 à 11.
